(19) **Europäisches Patentamt**
**European Patent Office**
**Office européen des brevets**

(11) Publication number: **0 174 150 B1**

## EUROPEAN PATENT SPECIFICATION

(45) Date of publication of patent specification: **24.04.91**

(51) Int. Cl.⁵: **G01R 13/32, H03K 3/017**

(21) Application number: **85306073.9**

(22) Date of filing: **27.08.85**

(54) **Trigger holdoff system for an oscilloscope.**

(30) Priority: **04.09.84 US 647003**

(43) Date of publication of application:
**12.03.86 Bulletin 86/11**

(45) Publication of the grant of the patent:
**24.04.91 Bulletin 91/17**

(84) Designated Contracting States:
**DE FR GB NL**

(56) References cited:
**US-A- 3 851 262**
**US-A- 4 121 164**
**US-A- 4 134 149**
**US-A- 4 251 754**

(73) Proprietor: **TEKTRONIX, INC.**
**Howard Vollum Park 14150 S.W. Karl Braun Drive**
**Beaverton Oregon 97005(US)**

(72) Inventor: **Blair, Bruce W.**
**16065 S.W. Autumn Lane**
**Beaverton Oregon 97005(US)**

(74) Representative: **Wright, Peter David John et al**
**R.G.C. Jenkins & Co. 26 Caxton Street**
**London SW1H 0RJ(GB)**

Rank Xerox (UK) Business Services

## Description

The present invention relates generally to a trigger holdoff system for an oscilloscope, and particularly to a trigger holdoff system for providing a stable trigger from a non-repetitive signal.

In conventional analog and digital oscilloscopes, an input signal is applied to a trigger generator, which generates a trigger signal in synchronism with the input signal. The trigger signal initiates a sweep generator to generate a sweep ramp signal in the analog oscilloscope or a time base control circuit to fill an acquisition memory in the digital oscilloscope. US-A-4 251 754 discloses an example of a prior art digital oscilloscope.

When monitoring a repetitive signal, a trigger holdoff circuit locks out the trigger signal from the sweep generator or the time base control circuit during a certain period of time to prevent premature starts of a new ramp excursion or a new acquisition cycle. Thus, the input signal is stably displayed on a screen or acquired into a memory in response to an identical trigger signal. However, the conventional trigger holdoff system functions properly only when the input signal is repetitive because the holdoff time period is fixed. That is, when the raw trigger signals are produced in groups of fixed numbers with variable time intervals therebetween, such as may be the output of a state machine, the timing of generation of a sweep ramp signal or an acquisition cycle is unstable.

US-A-3 851 262 discloses an oscilloscope comprising trigger generator means for generating a raw trigger signal at a predetermined point on an input signal; holdoff means coupled to said trigger generator means for issuing a valid trigger signal in response to receiving a predetermined plural number of said raw trigger pulses; and a triggerable time base system coupled to said holdoff means for receiving said valid trigger signals and being triggered thereby. The holdoff means is a divider which is provided to overcome problems of jitter arising in earlier circuits when a trigger pulse was generated at the same time as the end of the holdoff interval. Under these circumstances, the precise timing of the trigger signal was uncertain. To overcome this problem, the divider is inhibited from operating throughout the holdoff period, and at the end of the holdoff period is caused to count a predetermined number (e.g. two) of raw trigger pulses before issuing a valid trigger pulse. Consistent timing of the valid trigger pulse is thus ensured. However, this document does not address the problem mentioned in the preceding paragraph.

The present invention is characterised by a holdoff means which is arranged to provide a valid trigger pulse every time said predetermined number of raw trigger pulses has been generated, so that valid trigger pulses are provided in response to respective input signal patterns each comprising a predetermined number of said predetermined points. It will be understood that this arrangement differs from that disclosed in US-A-3 851 262 in which the holdoff means ignores raw trigger pulses provided during the holdoff period, and only starts to count at the end of this holdoff period.

In accordance with the present invention, a trigger holdoff system allows a desired trigger signal, among a repetitive group of raw trigger signals with variable time intervals therebetween, to be passed on to a sweep generator of an analog oscilloscope or an acquisition system of a digital oscilloscope. The holdoff circuit preferably has a divide by N counter, in which N is programmable under microprocessor control. Each raw trigger from the trigger generator is counted by the counter. When the counter reaches its terminal count, an enable signal is set so that the next raw trigger resets the counter and a trigger is passed to the acquisition system of the digital oscilloscope or a sweep generator of the analog oscilloscope.

An oscilloscope of the present invention can thus provide a stable trigger pulse from a group of raw triggers that repeat in a fixed pattern but shift in time.

An arrangement embodying the invention will now be described by way of example with reference to the accompanying drawings.

Fig. 1 is a block diagram of a digital oscilloscope employing a trigger holdoff system according to the present invention;

Fig. 2 is a waveform diagram to facilitate an understanding of the operation of the digital oscilloscope of Fig. 1; and

Fig. 3 is a detailed schematic of one embodiment according to the present invention.

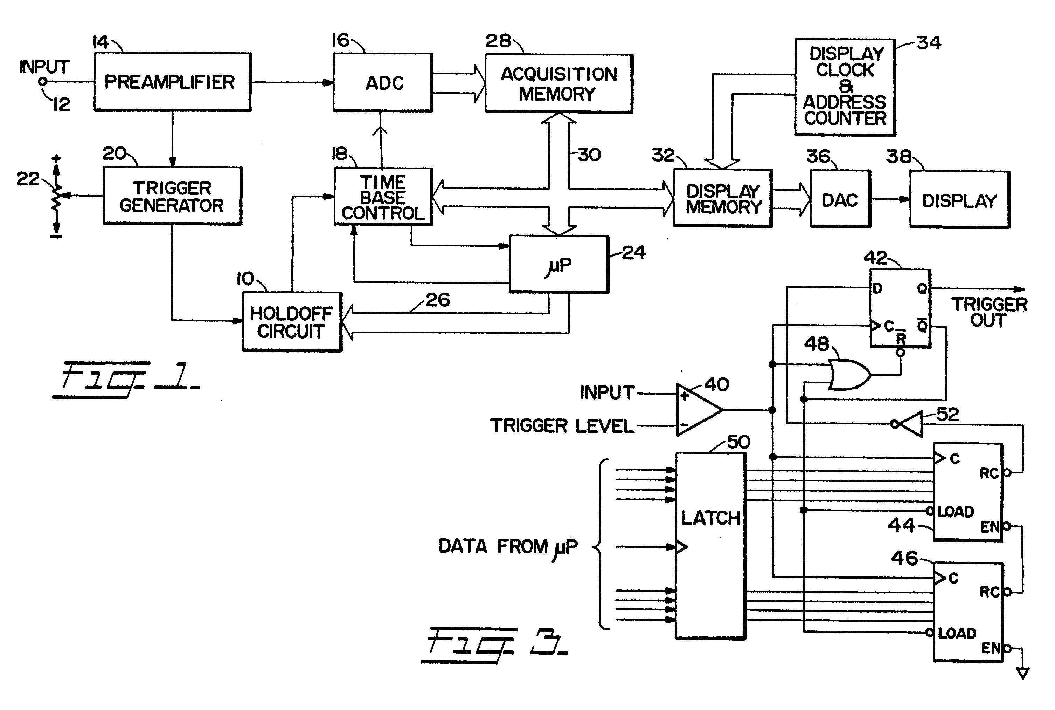

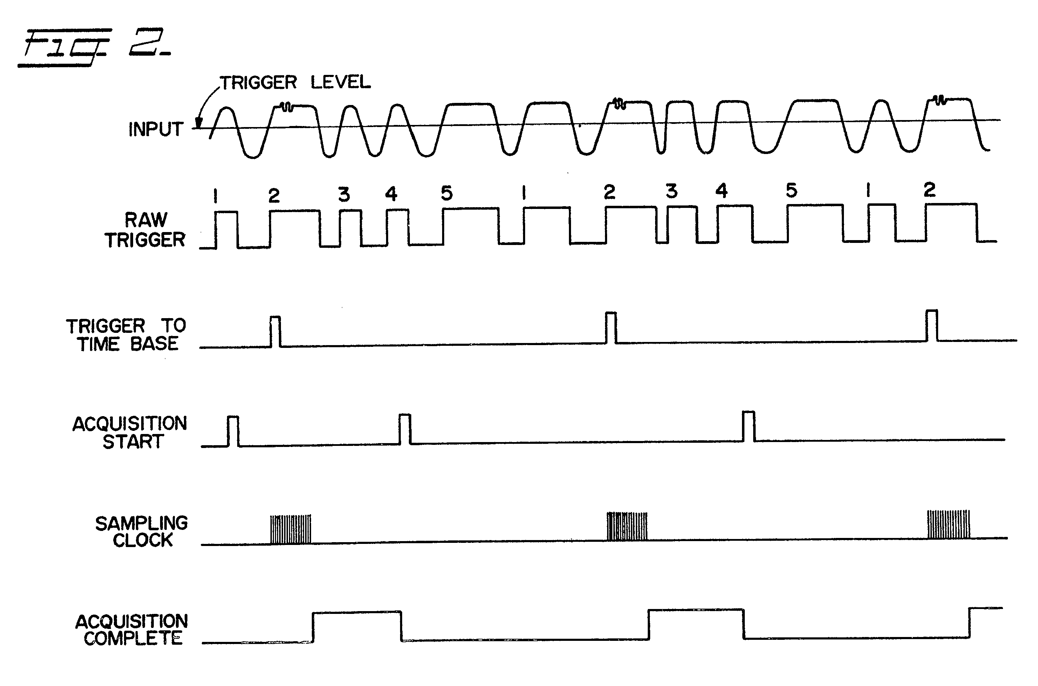

Referring to the block diagram of Fig. 1, a digital oscilloscope employs trigger holdoff circuit 10 in accordance with the present invention. The operation of the embodiment of Fig. 1 will be described in conjunction with the waveform diagram of Fig. 2, which depicts the relationship between signals. An analog signal (INPUT) is applied via input terminal 12 to preamplifier 14, which suitably may be a conventional gain switching amplifier for amplifying and attenuating the input signal to a suitable level. The preamplified signal is applied to analog-to-digital converter (ADC) 16, which converts the instantaneous value of the analog signal to n-bit parallel digital data at a rate determined by a sampling clock applied from time base control 18.

The preamplified signal is also applied to trigger generator 20, which generates raw triggers (RAW TRIG) at a reference level preselected by trigger level potentiometer 22. It should be noted that the raw triggers need not be repetitive, but may be a logic pattern consisting of a fixed number of triggers with variable time intervals therebetween. However, let us suppose that the input signal has at least one particular event in each pattern to be monitored on a display device. Let us suppose also that the logic pattern comprises five triggers, for purposes of explanation. The operator should know the fixed number of triggers in the logic pattern as described hereinafter. The raw triggers are applied to holdoff circuit 10 which has a divide by N counter. N corresponds to the fixed number of the raw triggers and is programmable under control of microporcessor 24 via bus 26. Accordingly, in this case, N is equal to five. When the counter reaches its terminal count, holdoff circuit 10 passes a trigger to time base control circuit 18, which also receives an acquisition start signal (ACQ START) from microprocessor 24 to enable control circuit 18. Simultaneously, an enable signal is set so that the next raw trigger reloads the counter.

Time base control circuit 18 sends a sampling clock signal to ADC 16 in response to initiation by the trigger pulse after being enabled by the start acquisition signal. The sampling clock is counted by an address counter within time base control circuit 18. The address counter may be preset with a predetermined number to provide either pretrigger or post-triggered operation in the well-known manner. The n-bit digital data is clocked into acquisition memory 28 according to addresses designated via bus 30 by the address counter, as is also well-known in the art.

When the address counter reaches a count of the maximum address, time base control circuit 18 provides an acquisition-complete signal (ACQ COMPLETE) to microprocessor 24, which in turn disables time base control circuit 18. During the high logic state of the ACQ COMPLETE signal, the acquired waveform data is transferred to display memory 32 under control of microprocessor 24 via bus 30. Microprocessor 24 reads the data from display memory 30 and processes it to measure amplitude and frequency, produce interpolated data etc. Display memory 30 is loaded with data representing a waveform by microprocessor 24. Now, microprocessor 24 is free to start another waveform acquisition and provide an acquisition start signal again to time base control circuit 18.

The stored data is clocked out of display memory 30 by display clock/address counter 34 and fed to digital-to-analog converter (DAC) 36 for converting the stored digital data to an analog signal applied to display device 38, as is well known in the art. Thus, the particular waveform event included in the fixed pattern of signals can be displayed.

Fig. 3 is a detailed schematic of one embodiment for generating a trigger holdoff signal in accordance with the present invention. The input signal is applied to a non-inverted input of comparator 40 having an inverted input receiving the trigger reference voltage preselected by potentiometer 22. Comparator 40 acts as the trigger generator of the raw trigger pulses. The raw trigger pulses are provided to a clock input of D-type flip flop (DFF) 42 and clock inputs of presettable down counters 44 and 46. DFF 42 and counters 44 and 46 respond to the positive going edge of the clock input. The raw trigger pulses are also provided to one input of OR gate 48 having the output connected to an inverted reset input ($\overline{R}$) of DFF 42. Eight bits of parallel data representing the fixed number of the triggers forming a pattern is provided to count latch circuit 50. Actually, for reasons that will become apparent, the data to be provided is the fixed number minus one. Substantially coincident with the arrival of the data, a strobe pulse edge is applied to count latch circuit 50 to latch the data. The data output of count latch circuit 50 is applied to down counters 44 and 46, which have inverted load inputs for loading the data upon load command. The load inputs are connected together to the other input of OR gate 48 and the $\overline{Q}$ output of DFF 42. Counter 46 is always enabled and sends a carry signal from the ripple carry output to enable counter 44 when the count of counter 46 reaches zero. Similarly, counter44 sends a carry signal to the D input of DFF 42 via inverter 52.

Operation of Fig. 3 is as follows: Assuming that the fixed number of the triggers forming a pattern is five as shown in Fig. 2, the eight-bit binary data (0000 0100), equivalent to the number reduced by one count from the fixed number of the triggers, is latched in count latch circuit 50 because the count from (0000 0100) to (0000 0000) is five. In the initial state, it is assumed that the binary data is loaded to counters 44 and 46, which are loaded by the higher four bits and the lower four bits, respectively. The positive going edge of the raw trigger causes counter 46 to count down from (0100). When the count reaches (0000), counter 44 is enabled by a carry signal from counter 46. Since the preset value of counter 44 is (0000), counter 44 causes its carry signal, which is applied to the D input of DFF 42, to go high. On the next trigger positive edge, the Q and $\overline{Q}$ outputs respectively go high and low. The $\overline{Q}$ output of DFF 42 reloads the binary data to counters 44 and 46 and causes the output of OR gate 48 to go low when the raw trigger pulse goes low. DFF 42 is reset by the low output of OR gate 48. Thus, the output pulse is produced at the Q output of DFF 42 every five raw triggers. Such operation is allowed to free run independent of the acquisition system of the digital storage. To change the trigger point, the next raw trigger pulse may be selected by incrementing or decrementing the count by one, for example, within the trigger pattern under control of microprocessor 24.

While the invention has been described in use for the digital oscilloscope, it is to be understood to those skilled in the art that the invention can be employed for an analog oscilloscope.

## Claims

1. An oscilloscope, comprising:
   trigger generator means (20) for generating a raw trigger signal at a predetermined point on an input signal;
   holdoff means (10) coupled to said trigger generator means (20) for issuing a valid trigger signal in response to receiving a predetermined plural number of said raw trigger pulses; and
   a triggerable time base system (18) coupled to said holdoff means (10) for receiving said valid trigger signals and being triggered thereby;
   characterised in that said holdoff means (10) is arranged to provide a valid trigger pulse every time said predetermined number of raw trigger pulses has been generated, so that valid trigger pulses are provided in response to respective input signal patterns each comprising a predetermined number of said predetermined points.

2. An oscilloscope as claimed in claim 1, including means (24) for altering said predetermined number.

3. An oscilloscope in accordance with claim 1 or 2, wherein said holdoff means (10) comprises counting means (42,44,46) for counting said raw trigger pulses and producing a valid trigger signal each time said predetermined number is reached.

4. An oscilloscope in accordance with claim 3, wherein said holdoff means (10) further includes a latch means (50) for storing data representative of said predetermined number to be loaded into said counting means (42,44,46).

5. An oscilloscope in accordance with claim 4, including a microprocessor (24) for loading data into said latch means (50).

6. An oscilloscope in accordance with claim 3, 4 or 5, wherein said counting means (42,44,46) comprises a presettable counter (44,46) for producing a count output signal when said predetermined number minus one is reached, and a logic circuit (42) responsive to said count output signal and the next raw trigger pulse to produce said valid trigger signal.

## Revendications

1. Un oscilloscope comprenant :
   des moyens générateurs de déclenchement (20) pour engendrer un signal brut de déclenchement à un point prédéterminé d'un signal d'entrée;
   des moyens de retard (10) couplés auxdits moyens générateurs de déclenchement (20) pour émettre un signal valide de déclenchement en réponse à la réception en nombre prédéterminé plusieurs desdites impulsions brutes de déclenchement; et
   un système de base de temps susceptible d'être déclenché, couplé auxdits moyens de retard (10) pour recevoir desdits signaux valides de déclenchement et être déclenché par ceux-ci;
   caractérisé en ce que ledit moyen de retard (10) est agencé pour fournir une impulsion valide de déclenchement chaque fois qu'un nombre prédéterminé d'impulsions brutes de déclenchement a été engendré, de sorte que des impulsions valides de déclenchement sont fournies en réponse à des configurations respectives de signaux d'entrée comprenant chacune un nombre prédéterminé desdits points prédéterminés.

2. Un oscilloscope selon la revendication 1, comprenant des moyens (24) destinés à modifier ledit nombre prédéterminé.

3. Un oscilloscope selon la revendication 1 ou 2 dans lequel ledit moyen de retard (10) comprend des moyens de comptage (42, 44, 46) pour compter lesdites impulsions brutes de déclenchement et produire un signal valide de déclenchement chaque fois qu'un nombre prédéterminé est atteint.

4. Un oscilloscope selon la revendication 3, dans lequel ledit moyen de retard (10) comprend en outre un moyen de verrouillage (50) pour mémoriser des données représentatives dudit nombre prédéterminé à charger dans ledits moyens de comptage (42, 44, 46).

5. Un oscilloscope selon la revendication 4, comprenant un microprocesseur (24) pour charger des données dans lesdits moyens de verrouillage (50).

6. Un oscilloscope selon la revendication 3, 4 ou 5, dans lequel ledit moyen de comptage (42, 44, 46) comprend
un compteur réglable au préalable (44, 46) pour produire un signal de sortie de compte lorsque ledit nombre prédéterminé moins un est atteint, et un circuit logique (42) sensible audit signal de sortie de compte et à ladite impulsion brute de déclenchement suivante pour produire ledit signal valide de déclenchement.

**Ansprüche**

1. Oszilloskop, bestehend aus:
einer Triggergeneratorvorrichtung (20) zur Erzeugung eines unverarbeiteten Triggersignals an einem vorbestimmten Punkt auf einem Eingangssignal;
einer Sperrvorrichtung (10), die mit der Triggergeneratorvorrichtung (20) gekoppelt ist, um ein gültiges Triggersignal als Reaktion auf den Empfang einer vorbestimmten Vielzahl von unverarbeiteten Triggerimpulsen auszugeben; und
ein triggerbares Zeitbasissystem (18), welches mit der Sperrvorrichtung (10) gekoppelt ist, um die gültigen Triggersignale zu seiner Triggerung zu empfangen;
**dadurch gekennzeichnet,**
daß die Sperrvorrichtung (10) so ausgelegt ist, daß sie nach Erzeugung einer vorbestimmten Anzahl unverarbeiteter Triggerimpulse einen gültigen Triggerimpuls abgibt, so daß gültige Triggerimpulse als Reaktion auf entsprechende Eingangssignalmuster erzeugt werden, die aus einer vorbestimmten Anzahl vorbestimmter Punkte bestehen.

2. Oszilloskop nach Anspruch 1,
mit einer Vorrichtung (24) zur Änderung der vorbestimmten Anzahl.

3. Oszilloskop nach Anspruch 1 oder 2,
worin die Sperrvorrichtung (10) aus einer Zählvorrichtung (42, 44, 46) zum Zählen der unverarbeiteten Triggerimpulse und zur Erzeugung eines gültigen Triggersignales bei jedem Erreichen der vorbestimmten Anzahl besteht.

4. Oszilloskop nach Anspruch 3,
worin die Sperrvorrichtung (10) weiterhin aus einer Signalspeichervorrichtung (50) zur Speicherung von Daten besteht, welche die vorbestimmte Anzahl darstellen, zur Ladung in die Zählvorrichtung (42, 44, 46).

5. Oszilloskop nach Anspruch 4,
weiterhin bestehend aus einem Mikroprozessor (24) zur Ladung von Daten in die Signalspeichervorrichtung (50).

6. Oszilloskop nach den Ansprüchen 3, 4 oder 5,
worin die Zählvorrichtung (42, 44, 46) aus einem voreinstellbaren Zähler (44, 46) zur Erzeugung eines Zählausgangssignales bei Erreichen einer vorbestimmten Anzahl minus Eins, und einer logischen Schaltung (42), die auf das Zählausgangssignal und den nächsten unverarbeiteten Triggerimpuls reagiert und ein gültiges Triggersignal erzeugt, besteht.

INPUT
12

14 PREAMPLIFIER
16 ADC
28 ACQUISITION MEMORY

34 DISPLAY CLOCK & ADDRESS COUNTER

20 TRIGGER GENERATOR
22

18 TIME BASE CONTROL

30

32 DISPLAY MEMORY
36 DAC
38 DISPLAY

24 μP

10 HOLDOFF CIRCUIT

26

_Fig 1._

42 D Q
C
R Q
TRIGGER OUT

48

40
INPUT +
TRIGGER LEVEL −

52

50 LATCH

DATA FROM μP

44 C RC
LOAD
EN

46 C RC
LOAD
EN

_Fig 3._

EP 0 174 150 B1

FIG 2.

EP 0 174 150 B1